**Europäisches Patentamt**

**European Patent Office**

**Office européen des brevets**

(19)

(11) Publication number : **0 290 036 B1**

# (12) EUROPEAN PATENT SPECIFICATION

(45) Date of publication of patent specification :
**12.04.95 Bulletin 95/15**

(51) Int. Cl.⁶ : **H05H 1/46, H01J 37/32**

(21) Application number : **88107319.1**

(22) Date of filing : **06.05.88**

(54) **Plasma treatment apparatus.**

(30) Priority : 08.05.87 JP 110752/87
02.06.87 JP 138772/87
03.09.87 JP 219179/87

(43) Date of publication of application :
**09.11.88 Bulletin 88/45**

(45) Publication of the grant of the patent :
**12.04.95 Bulletin 95/15**

(84) Designated Contracting States :
**DE GB**

(56) References cited :
EP-A- 0 171 949
DE-A- 3 144 016
US-A- 4 401 054
US-A- 4 559 100

(73) Proprietor : **HITACHI, LTD.**
**6, Kanda Surugadai 4-chome**
**Chiyoda-ku, Tokyo 100 (JP)**
Proprietor : **HITACHI SERVICE ENGINEERING**
**CO., LTD.**
**9-1, Ohsecho-2-chome**
**Hitachi-shi Ibaraki-ken (JP)**

(72) Inventor : **Mochizuki, Yasuhiro**
**421 Takaba**
**Katsuta-shi (JP)**
Inventor : **Momma, Naohiro**
**21-13, Ishinazakacho-1-chome**
**Hitachi-shi (JP)**
Inventor : **Takahashi, Shigeru**
**1455-2, Ozawacho**
**Hitachiota-shi (JP)**
Inventor : **Fukuda, Takuya**
**19-1-304, Ishinazakacho-1-chome**
**Hitachi-shi (JP)**
Inventor : **Suzuki, Noboru**
**29-21, Nishinarusawacho-2-chome**
**Hitachi-shi (JP)**
Inventor : **Sonobe, Tadasi**
**1-1, Sekitanishi-1-chome**
**Nakosomachi Iwaki-shi (JP)**
Inventor : **Chiba, Kiyoshi**
**7-9, Jonancho-2-chome**
**Hitachi-shi (JP)**
Inventor : **Suzuki, Kazuo**
**4-9, Higashitagacho-4-chome**
**Hitachi-shi (JP)**

(74) Representative : **Patentanwälte Beetz - Timpe -**
**Siegfried Schmitt-Fumian - Mayr**
**Steinsdorfstrasse 10**
**D-80538 München (DE)**

## Description

BACKGROUND OF THE INVENTION

The present invention relates to a plasma treatment apparatus used for depositing a desired substance on a substrate to form a thin film.

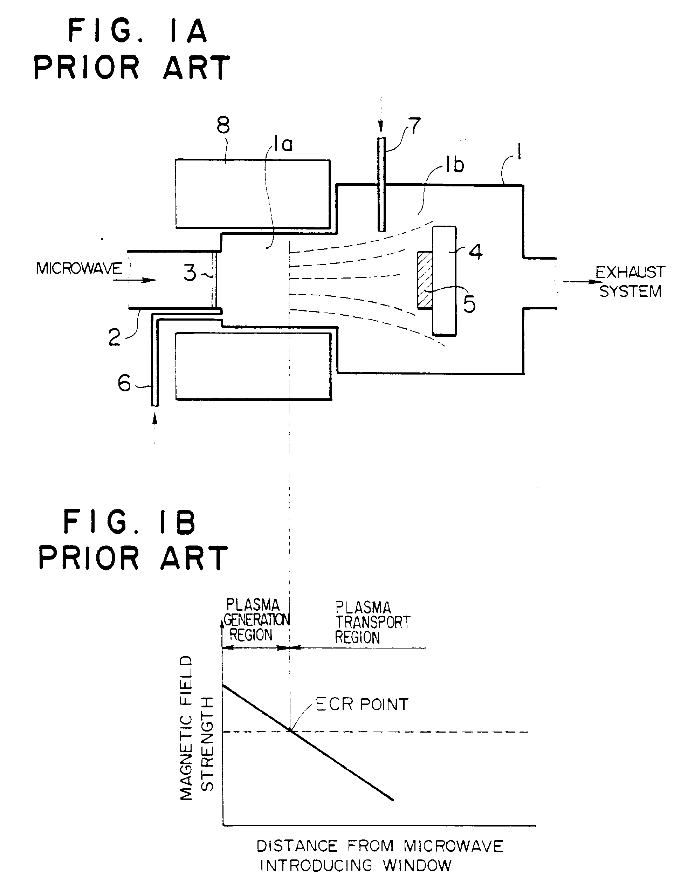

A method of forming a thin film on a predetermined substrate is used in many fields of the art, for example, in the fabrication process of a semiconductor integrated circuit. Generally, the formation of a thin film is carried out in an atmosphere of high temperatures. In the fabrication of a semiconductor integrated circuit, however, there is the case where a thin film is formed on a semiconductor integrated circuit which has been fabricated. (In this case, the semiconductor integrated circuit corresponds to the above-mentioned substrate.) When the thin film is formed on such a semiconductor integrated circuit, there is a fear that a bad influence is given to the semiconductor integrated circuit if the formation of the thin film is conducted in an atmosphere of high temperatures. This is a problem which is not limited to the semiconductor integrated circuit but is common to any substrate affected by the high temperatures. In recent years, a microwave plasma treatment apparatus has been proposed as means for solving such a problem. The microwave plasma treatment apparatus will be explained by virtue of Fig. 1A and 1B.

Fig. 1A shows a schematic view of the conventional microwave plasma treatment apparatus and in Fig. 1B the distribution of strengths of a magnetic field in the apparatus shown in Fig. 1A. One example of the shown conventional microwave plasma treatment apparatus has been disclosed by U.S. Patent No. 4,401,054. In Fig. 1A, reference numeral 1 designates a vacuum vessel which is evacuated or exhausted by means of a vacuum pump not shown. Numeral 1a designates a discharge section in the vacuum vessel 1, and numeral 1b a reaction section in the vacuum vessel 1. Numeral 2 designates a waveguide for guiding a microwave emitted from a magnetron not shown, and numeral 3 a microwave introducing window made of an insulating material such as quartz for introducing the guided microwave into the vacuum vessel 1. Numeral 4 designates a supporting plate (or holder) provided at the reaction section 1b, and numeral 5 a substrate which is supported on the supporting plate 4 and on which a thin film is to be formed. Numeral 6 designates a first gas conduit for introducing a first predetermined gas into the discharge section 1a, and numeral 7 a second gas conduit for introducing a second predetermined gas into the reaction section 1b. Numeral 8 designates an electromagnetic coil wound around the vacuum vessel 1 for producing in the vacuum vessel 1 a magnetic field as shown in Fig. 1B.

The operation of the above-mentioned microwave plasma treatment apparatus will now be explained referring to the magnetic field strength distribution shown in Fig. 1B. In Fig. 1B, the abscissa represents a distance in the vacuum vessel 1 from the microwave introducing window 3 and the ordinate represents the strength of the magnetic field produced by the electromagnetic coil 8.

After the vacuum vessel 1 has been evacuated to a pressure not higher than 0,13 mPa ($10^{-6}$ Torr), a predetermined gas, for example, an oxygen gas is introduced at a predetermined pressure from the gas conduit 6 while a microwave is introduced from the microwave introducing window 3, so that a plasma of oxygen gas is produced. At this time, if a magnetic field having a predetermined strength is applied by the electromagnetic coil 8, electrons in the plasma make their circular motions by a Lorentz' force and impinge against non-ionized oxygen molecules which in turn are ionized to release electrons therefrom. In this manner, the ionization of the oxygen gas progresses at a rapid speed through the motions of electrons, thereby generating a plasma of oxygen gas at a high density in the discharge section 1a.

The above-mentioned motions (circular motions) of electrons do not occur under the mere existence of the microwave and the magnetic field but are generated through a resonance phenomenon produced only when a specified magnetic field exists for a specified microwave. Namely, when the introduced microwave has a frequency of 2.45 GHz, the circular motions of electrons take place at a point wherein the strength of the magnetic field is 0,0875T (875 Gauss). Since in Fig. 1B the level of 0,0875T (875 Gauss) is represented by broken line and the magnetic field strength distribution in the vacuum vessel 1 is represented by solid line, a point of occurrence of the circular motions of electrons is on a line indicated by one-dotted chain line. Such a point is called an electron cyclotron resonance (ECR) point. A region on the side of the ECR point near the microwave introducing window 3 is called a plasma generation region. The ECR point can also be called an ECR portion since it may have a plane-like or three-dimensional extent.

The plasma thus generated moves toward the reaction section 1b since the evacuation is made. This movement of the plasma is owing to the evacuation as well as the fact that electron ions of positive charges are attracted by a group of electrons of negative charges which have moved through the circular motions thereof. A region on the side of the ECR point near the substrate 5 is called as a plasma transport region. If a predetermined gas, for example, a monosilane gas ($SiH_4$) is introduced from the gas conduit 7 into the reaction section 1b when the plasma is moving, the monosilane gas impinges against the transported plasma so that the monosilane gas is activated and reacts on the oxygen gas to produce a silicon oxide ($SiO_2$) which is deposited on the substrate 5. Thus, a thin film of silicon oxide is formed on the substrate 5.

Any desired thin film can be formed by selecting gases introduced from the conduits 6 and 7.

The above-mentioned microwave plasma treatment apparatus is remarkably excellent in the case where it is desired to form a thin film on a substrate which is liable to be affected by high temperatures. However, no sufficient consideration has been paid to the efficiency of reaction of a gas as a main raw material introduced from the gas conduit 7 or the rate of deposition of a substance deposited on the substrate 5 and the quality of a thin film formed.

Another example of the conventional plasma treatment apparatus utilizing the ECR has been disclosed by, for example, JP-A-56-155535 and JP-A-57-79621 and is shown in Fig. 2. In the plasma treatment apparatus shown in Fig. 2, plasma-activated species are produced in a plasma generation chamber 213 and a divergent magnetic field generated by a magnetic field generation coil 204 causes the flow of plasma to impinge upon an object 211 to be treated which is disposed at a position sufficiently away from a region at which the efficiency of generation of the plasma activated species is the maximum.

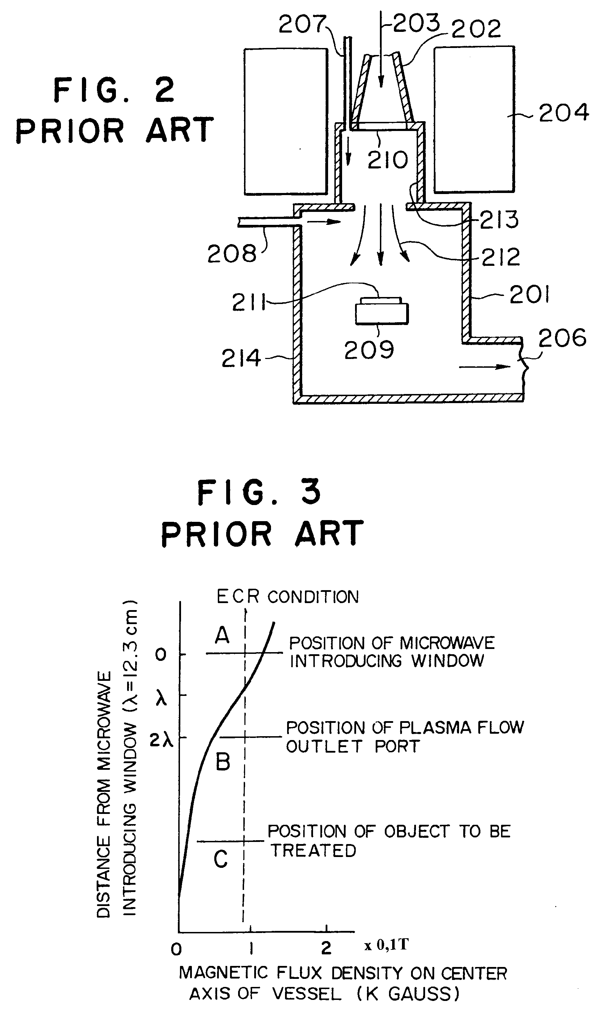

In the just-mentioned conventional plasma treatment apparatus, since a vacuum vessel 201 includes the plasma generation chamber 213 and a plasma treatment chamber 214 having a relatively large axial length, as shown in Fig. 2, the size of the vacuum vessel 201 becomes large and hence the size of an exhaust port 206 and the size of the magnetic field generation coil 204 becomes correspondingly large.

Experiments by the present inventors have revealed that in a plasma treatment utilizing the ECR, the treatment characteristics depend on a distance between the ECR position and the object 211 to be treated and are more excellent as this distance is smaller. It has been further revealed that if the concentration of a gas at the ECR position is made high, a microwave 203 is almost absorbed at the ECR position and does not reach the object 211 so that the reflection of the microwave from the object 211, an object supporting base 209, etc. disapears.

In the construction of Fig. 2, it may be considered to shorten the axial length of the vacuum vessel 201 by positioning the object 211 near a microwave introducing window 210. In that case, however, the reflection of the microwave from the object 211 is present, thereby lowering the efficiency treatment with plasma and the plasma treatment characteristics.

The conventional microwave treatment apparatus involving a magnetic field can be classified broadly into two types, i.e. (1) one type in which a magnetic field generating portion is disposed outside of a plasma generation chamber and the flow of plasma produced is applied onto a surface to be treated which is positioned substantially perpendicular to the direction of a magnetic line of force, as has been disclosed by JP-A-56-155535, and (2) the other type in which a magnetic field generating portion is disposed outside of a vacuum vessel and the flow of plasma is applied onto a surface to be treated which is positioned substantially parallel to the direction of a magnetic line of force, as has been disclosed by JP-A-58-125820.

In either of the above-mentioned types (1) and (2), since the magnetic field generating portion is disposed outside of the vacuum vessel, it is difficult to improve the efficiency of utilization of a magnetic field and to make the size of the apparatus small. Namely, since a coil or permanent magnet for generation of a magnetic field is disposed outside of the vacuum vessel for generating a magnetic field necessary for the generation of a plasma in the vacuum vessel, the effective utilization of the magnetic field generated cannot be expected and hence it is necessary to strengthen the generated magnetic field by supplying a large current through the coil or by making the size of the magnet large. Therefore, there is a problem that the volume of the treatment apparatus or the floor area occupied by the treatment apparatus becomes large.

Further, in the above-mentioned types (1) and (2) of apparatuses, no consideration is paid to the control of the distribution of reactive gases and the distribution deposition seeds in the vacuum vessel. Therefore, the vacuum vessel is filled with excess reactive gases and deposition seeds so that the formation of a film is effected on not only the surface of an object to be treated but also an inner wall of the vacuum vessel. This results in a problem that alien or undesired substances (or deposite) are produced in flakes, a problem that the frequency in maintenance becomes high, and a problem that a large exhaust system is required for exhausting the excess reactive gases.

In addition, in the case where a cylinder-like structure such as a photosensitive drum is to be treated, the following problems exist.

Namely, in the above-mentioned type (1) disclosed by JP-A-56-155535, the diameter of the vacuum vessel must be made greatly larger than the dimension of the cylinder-like structure in order that a sufficient space of ventilation of a gas can be established to make uniform the distribution of deposition of a film to be formed and a flow of the gas and the evacuation can be facilitated. Therefore, the apparatus must be made remarkably large. Further, since only a part of a surface to be treated is treated at a time, a total treatment time becomes long.

In the type (2) disclosed by JP-A-58-125820, no consideration is paid to the facts that the quality of a film formed greatly depends on a distance between the ECR point and a surface to be treated and that the quality of a film formed on a surface greatly distanced from the ECR point becomes unhomogeneous.

## SUMMARY OF THE INVENTION

A first object of the present invention is to provide a microwave plasma treatment apparatus capable of improving the reaction efficiency (or film deposition rate) and the film quality.

To achieve the first object, a microwave plasma treatment apparatus according to one aspect of the present invention and comprising a vacuum vessel including a discharge section, a reaction section, a first gas introducing port and a second gas introducing port, microwave introducing means for introducing a microwave into the discharge section, magnetic field generating means for forming a magnetic field in the vacuum vessel, and a substrate placed in the reaction section, a thin film being formed on the substrate by introducing first and second predetermined gases from the first and second gas introducing ports, is characterized in that the first gas introducing port and the second gas introducing port are disposed on the microwave introduction side with respect to an electron cyclotron resonance (ECR) point or portion defined by the microwave and the magnetic field while the substrate is disposed on a side reverse to the microwave introduction side with respect to the ECR point.

The first gas introduced from the first gas introducing port into the vacuum vessel turns into a plasma by virtue of the microwave and is transported toward the substrate. On the other hand, the second gas introduced from the second gas introducing port into the vacuum vessel impinges against the plasma of the first gas to be activated as a plasma and is also activated as a plasma by the microwave. Electrons in these plasmas make their motions (or circular motions) at the ECR point, thereby producing a plasma of a higher density. As a result, the initial reaction is rapidly accelerated so that a reaction product is deposited on the substrate.

A second object of the present invention is to provide a plasma treatment apparatus the size of which can be made small without lowering the plasma treatment characteristics.

To achieve the second object, a plasma treatment apparatus according to another aspect of the present invention is characterized in that a reactive gas is introduced within an ECR plane formed substantially perpendicular to the direction of propagation of a microwave, thereby providing a state in which the concentration of the reactive gas is high in the ECR plane.

With the above-mentioned feature, a region including the ECR plane forms a high absorption band of the microwave, thereby remarkably lowering the transmittance of the microwave therethrough. Therefore, even if a microwave introducing portion and an object to be treated are positioned in the vicinity of the ECR position, the plasma treatment becomes possible without lowering the plasma treatment characteristics. As a result, at least the length of the vacuum vessel in the direction of propagation of the microwave can be shortened remarkably as compared with that of the conventional apparatus, thereby providing a plasma treatment apparatus of a small size.

The plasma treatment characteristics including the film formation characteristic, the etching rate, etc. are substantially determined by the type, concentration and lifetime of plasma-activated species. Since a position at which the plasma-activated species are produced at the greatest number corresponds to the ECR position, the type and concentration of plasma-activated species are determined at the ECR position and whether or not the plasma-activated species reach the object to be treated is determined by a distance between the ECR position and the object to be treated. Also, the propagation of the microwave depends on the absorption thereof by molecules, atoms, ions, etc. at the ECR position and in the vicinity thereof. The higher the concentration of those gases, the lower the transmittance of the microwave at the ECR position and in the vicinity thereof becomes. Accordingly, if the concentration of reactive gases in the ECR plane (or a plane having the magnetic flux density B which satisfies $\omega = B \cdot \dfrac{e}{m}$, $\omega$ being the frequency of the microwave, $\underline{e}$ being the charge amount of the electron and $\underline{m}$ being the mass of the electron) formed substantially perpendicular to the direction of propagation of the microwave is enhanced by blowing or driving a reactive gas toward the ECR plane or letting a reactive gas flow in parallel to planes including the ECR plane, a high absorption band of the microwave is formed in a region including the ECR plane, thereby suppresing the propagation of the microwave to the object to be treated or the reflection of the microwave from the object or an object supporting base. Therefore, the practical efficiency of the microwave introduced is not deteriorated. Accordingly, even if the microwave introducing portion and the object to be treated are positioned in the vicinity of the ECR position, the plasma treatment can be performed without lowering the plasma treatment characteristics.

A third object of the present invention is to provide a plasma treatment apparatus which has a compact size and in which the formation of a uniform film can be made at a high speed and the maintenance can be simplified.

To achieve the third object, a plasma treatment apparatus according to a further aspect of the present invention is characterized in that a magnetic field generating portion is disposed inside of an object to be treated with a plasma and a reactive gas is blown onto a surface of the object from a near distance. With such features, the concentration of the reactive gas in the vicinity of the surface of the object to be treated is enhanced and the optimum magnetic field strength distribution for causing an electron cyclotron resonance is produced in the vicinity of the surface of the object.

By disposing the magnetic field generating portion inside of the object to be treated with the plasma, a compact-sized magnetic field generating portion can be realized easily. Also, since the surface of the object to be treated is positioned near the magnetic field generating portion so that the strength of a magnetic field necessary for causing the ECR is generated in the vicinity of the surface of the object to be treated with the plasma, a coil current can be reduced or the size of a magnet can be made small. As a result, the whole of the apparatus can be constructed with a compact size.

The object mentioned hereinbefore are achieved by the plasma treatment apparatus as characterised in claims 1 and 2.

In a microwave plasma treatment involving a magnetic field, the film formation rate is proportional to the concentration of a reactive gas at a position where the ECR is caused, and is substantially inversely proportional to a distance between the ECR position and a surface to be treated. As that distance is shorter, the denseness of a film formed is increased or a satisfactory film can be obtained. In the present invention, by enhancing the concentration of a reactive gas in the vicinity of the surface to be treated and causing the ECR at such a position, the film formation rate can be increased, thereby providing the film having a satisfactory quality.

Further, since the reaction takes place in the surface to be treated, the most of deposition seeds deposit on a desired surface. It is not necessary to fulfill the whole of the vacuum vessel with a reactive gas. Therefore, the amount of deposits which may adhere to the inner wall of the vacuum vessel, can be reduced. Further, the efficiency of utilization of the reactive gas can be improved and the amount of non-reacted gases to be exhausted can be reduced correspondingly.

The above-mentioned features can be employed in a combination thereof.

## BRIEF DESCRIPTION OF THE DRAWINGS

Fig. 1A is a schematic view of one example of the conventional microwave treatment apparatus and Fig. 1B the distribution of magnetic field strengths in the apparatus.

Fig. 2 is a longitudinal cross section of another example of the conventional plasma treatment apparatus;

Fig. 3 is the distribution of magnetic flux densities along the center axis of a vacuum vessel of the apparatus shown in Fig. 2;

Fig. 4 is a longitudinal cross section of still another example of the plasma treatment apparatus referred to for comparison;

Fig. 5A is a schematic view of a microwave plasma treatment apparatus according to an embodiment of the present invention and Fig. 5B the distribution of magnetic field strengths in the apparatus;

Fig. 6 is a longitudinal cross section of a plasma treatment apparatus according to another embodiment of the present invention;

Fig. 7 is the distribution of magnetic flux densities along the center axis of a vacuum vessel of the apparatus shown in Fig. 6;

Fig. 8 is a longitudinal cross section of a plasma treatment apparatus according to still another embodiment of the present invention;

Fig. 9 is a longitudinal cross section of a plasma treatment apparatus according to a further embodiment of the present invention;

Figs. 10A and 10B are the distributions of magnetic flux densities in the apparatus shown in Fig. 9;

Fig. 11 is a longitudinal cross section of a plasma treatment apparatus according to a still further embodiment of the present invention;

Figs. 12A and 12B is the distributions of magnetic flux densities in the apparatus shown in Fig. 11; and

Fig. 13 is a longitudinal cross section of a plasma-activated CVD apparatus used in the embodiment shown in Fig. 5A.

## DESCRIPTION OF THE PREFERRED EMBODIMENTS

The present invention will now be explained in reference to embodiments shown in the accompanying drawings.

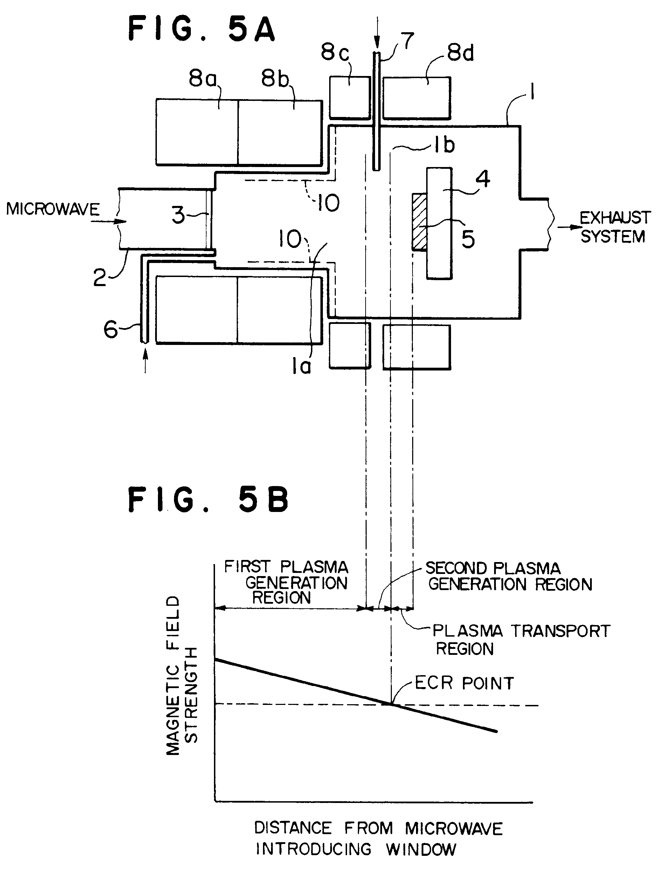

Fig. 5A shows a schematic view of a microwave plasma treatment apparatus according to an embodiment of the present invention and Fig. 5B the distribution of magnetic field strengths in the apparatus shown in Fig. 5A. In Fig. 5A, the same parts or components as those in Fig. 1A are designated with the same reference numerals as those in Fig. 1A. Therefore, explanation of those parts or components will be omitted. In Fig. 5A, reference numerals 8a, 8b, 8c and 8d designate four electromagnetic coils wound around the vacuum vessel 1. The conventional apparatus shown in Fig. 1A and the apparatus of the present embodiment shown in Fig. 5A are different from each other in the number of electromagnetic coils and the arrangement thereof.

Next, the operation of the apparatus of the present embodiment will be explained referring to the magnetic field strength distribution shown in Fig. 5B. Like Fig. 1B, the abscissa of Fig. 5B represents a distance from the microwave introducing window 3 and the ordinate thereof represents the strength of a magnetic field. Also, broken line indicates the magnetic field strength of 0,0875T (875 Gauss). In the present embodiment, a magnetic field strength as shown in Fig. 5B is formed in the vacuum vessel 1 by adjusting currents supplied to the electromagnetic coils 8a to 8d. Namely, an ECR point is caused to exist in the vicinity of the substrate 5 and near the substrate 5 as compared with the gas conduit 7.

When a gas is introduced from the gas conduit 6 under such a magnetic field strength distribution, this gas develops into a plasma by virtue of a microwave. In Fig. 5B, this plasma region is termed a first plasma generation region. The plasma is transported toward the substrate 5. A raw material gas from the gas conduit 7 is introduced in the course of transport. This raw material gas turns into a plasma under the influence of the microwave as well as through the impingement against the plasma transported from the first plasma generation region. A region where the raw material gas turns into the plasma is termed a second plasma generation region in Fig. 5B.

When those plasma reach the ECR point, electrons in the plasma make their motions (or circular motions). The repeated impingement of the circularly moving electrons and particles in the plasma produces a plasma of a higher density. Thus, a desired reaction is rapidly accelerated to yield a reaction product which in turn is transported to the substrate 5 and deposited thereon. In Fig. 5B, a region between the ECR point and a surface of the substrate 5 is termed a plasma transport region.

Instead of the provision of the gas conduit 6, the discharge section la of the vacuum vessel 1 may be formed with a double cylinder structure as indicated by dotted line 10 in Fig. 5B to introduce a gas through a space defined by between the two cylinders. In that case, a more uniform gas flow can be provided.

Now, a concrete example of forming a film of silicon oxide by use of the apparatus of the present embodiment will be described. Currents supplied to the electromagnetic coils 8a to 8d were adjusted to control the distribution of magnetic field strengths so that an ECR point is located just before the substrate 5 at the maximum magnetic field strength of 0,25T (2500 Gauss). Oxygen was supplied at 140 ml/min from the gas conduit 6 while a mixture gas of monosilane ($SiH_4$) at 20 ml/min and helium at 80 ml/min was supplied from the gas conduit 7. A pressure in the vacuum vessel 1 was 0,13 Pa (1.0 mTorr). A silicon wafer was used as the substrate 5 and a microwave having a frequency of 2.45 GHz and an output of 400 W was used. The results are shown in Table 1 together with the results in the case where a film was formed by using the conventional apparatus and the results in the case where a film was formed at an atmosphere of high temperature (or through thermal oxidization).

Table 1

| | | Apparatus of Embodiment | Conventional Apparatus | Thermal oxidization |
|---|---|---|---|---|
| Conditions of Film Formation | Maximum Magnetic field Strength | **0,25T** (2500 Gauss) | 0,1T (1000 Gauss) | - |
| | Substrate Temperature | about 100°C | about 100°C | 1100°C |
| | Reactive Gas | $SiH_4 + O_2$ | $SiH_4 + O_2$ | $H_2O$ |
| Film Formation Characteristics | Deposition Rate | 370 nm/min | about 200 nm/min | - |
| | Film Thickness Distribution (5" $\phi$) | ±4% | ±4% | - |
| Properties of Deposited Film | Peak Position of Infrared Absorption Spectrum | 1080 $cm^{-1}$ | 1072 $cm^{-1}$ | 1082 $cm^{-1}$ |
| | Refractive index | 1.455-1.460 | 1.440-1.465 | 1.45-1.46 |
| | Etch Rate (Buffer HF) | (6 - 20 Å/s) 0,6 - 2 nm/s | (8 - 100 Å/s) 0,8 - 10 nm/s | (6 - 10 Å/s) 0,6 - 1 nm/s |
| | Etch Rate (P Etchant) | (6 - 70 Å/s) 0,6 - 7 nm/s | (200 - 600 Å/s) 20 - 60 nm/s | (2 Å/s) 0,2 nm/s |
| | Surface-state Charge Density | $(6-10) \times 10^{10}$ $cm^{-2}$ | $(6-10) \times 10^{10}$ $cm^{-2}$ | $8 \times 10^{10}$ $cm^{-2}$ |

EP 0 290 036 B1

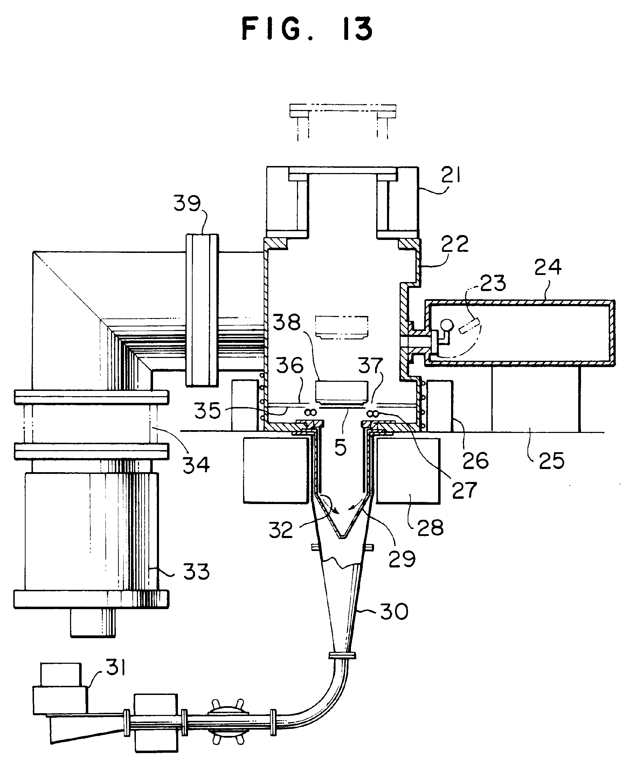

Fig. 13 is a detail drawing of a plasma-activated CVD (Chemical Vapor Deposition) apparatus used in the present embodiment. Referring to Fig. 13, reference numeral 21 designates a lift driver, numeral 22 a reaction chamber, numeral 23 a gate valve, numeral 24 a sample or object taking-in/out chamber, numeral 25 a sample exchange driver, numeral 26 a control magnetic field generating coil, numeral 27 a control electrode, numeral 28 an ECR coil, numeral 29 a discharge tube, numeral 30 a waveguide for guiding a microwave, numeral 31 a magnetron for generating the microwave, numeral 32 a plasma gas blowing port, numeral 33 a turbo molecular pump, numeral 34 a bellows, numeral 35 a shutter, numeral 36 a damper, numeral 37 a reactive gas blowing port, numeral 38 a substrate holder (or heating base), and numeral 39 a throttle valve. In this apparatus, the plasma blowing port 32 has a double cylinder structure in which a cylindrical member is provided inside of the discharge tube 29. The reactive gas blowing port 37 has a plurality of nozzles on the inner periphery of a ring-like pipe.

In Table 1, the etching rate shows a speed at which a silicon oxide film formed dissolves, and a solvent is shown in the parenthesis. The solvent "Buffer HF" is a solution containing the mixture of HF (49%) and $NH_4F$ at the ratio of 1 : 6, and the solvent "P.Etchant" is a solution containing the mixture of HF (49%), $HNO_3$ (69%) and $H_2O$ at the ratio of 1.5 : 1 : 30.

Looking at the deposition rate in Table 1, it is seen that the apparatus according to the present embodiment can form a film at the deposition rate about twice as high as that in the conventional apparatus, thereby remarkably improving the efficiency of reaction. This may be considered because the raw material gas introduced from the gas conduit 7 is activated by a plasma from the plasma generation region as well as the introduced microwave.

From the review of the peak position of infrared absorption spectrum and the etching rate in Table 1, it is seen that a thin film formed in accordance with the present embodiment has a more excellent quality than that of a thin film formed by the conventional apparatus. For example, the etch rate of the thin film formed in accordance with the present embodiment is smaller than that of the thin film formed by the conventional apparatus which the thin film of the present embodiment is hard to dissolve or is dense. Generally, a thin film formed through thermal oxidization is characterized by its high denseness. The denseness of the thin film formed according to the present invention is close to that of the thin film formed through thermal oxidization.

Next, a concrete example in which a film of silicon is formed by using the apparatus of the present embodiment will be explained. With the same construction of the apparatus as that used in the above-explained concrete example in which the film of silicon oxide has been formed, helium was supplied at 60 ml/min from the gas conduit 6 while monosilane was supplied at 20 - 100 ml/min from the gas conduit 7. A pressure in the vacuum vessel 1 was 0,11 Pa (0.8 mTorr). As a result, it has been found that a silicon film is formed at the maximum deposition rate of 600 nm/min which is greatly improved as compared with the maximum deposition rate of 100 nm/min at the conventional apparatus. Further, the deposited silicon film was examined by Raman spectrography and X-ray diffraction. The Raman spectrographic examination has revealed that the proportion of crystal components exsisting in the silicon film deposited in accordance with the present embodiment is about ten times as high as that in the silicon film formed by the conventional apparatus, and the examination by X-ray diffraction has revealed that the X-ray diffraction intensity of the silicon film formed in accordance with the present embodiment is 200 - 1000 times as high as that of the silicon film formed by the conventional apparauts. This means that the silicon film formed by the conventional apparatus is mainly composed of amorphous silicon while the silicon film formed in accordance with the present embodiment is mainly composed of polycrystalline silicon and has a remarkably improved denseness.

Thus, in the present embodiment, since currents supplied to electromagnetic coils are adjusted so that an ECR point is caused to exist near a substrate as compared with a raw material introducing position and in the vicinity of the substrate, the efficiency of reaction of the raw material gas and the quality of a film formed can be improved. The improvement of the reaction efficiency can improve the rate of deposition of the film. Further, it can reduce the amount of consumption of the raw material gas and facilitates the processing of waste gas and the maintenance.

Though the above explanation of the embodiment has been made in the example in which the ECR point is caused to exist in the vicinity of the substrate, it is apparent that the ECR point may exist at any point (for example, the point shown in Fig. 2) if the substrate is caused to be positioned in the vicinity of the ECR point. In any case, the raw material introducing position exists away from the substrate as compared with the ECR point. Also, the number and/or arrangement of electromagnetic coils can be selected arbitrarily in accordance with various condition.

As has been mentioned above, since the first gas introducing port and the second gas introducing port are disposed the microwave introduction side with respect to the ECR point, the reaction efficiency of the raw material gas and the quality of a film formed can be improved. The improvement of the reaction efficiency can improve the rate of deposition of the film.

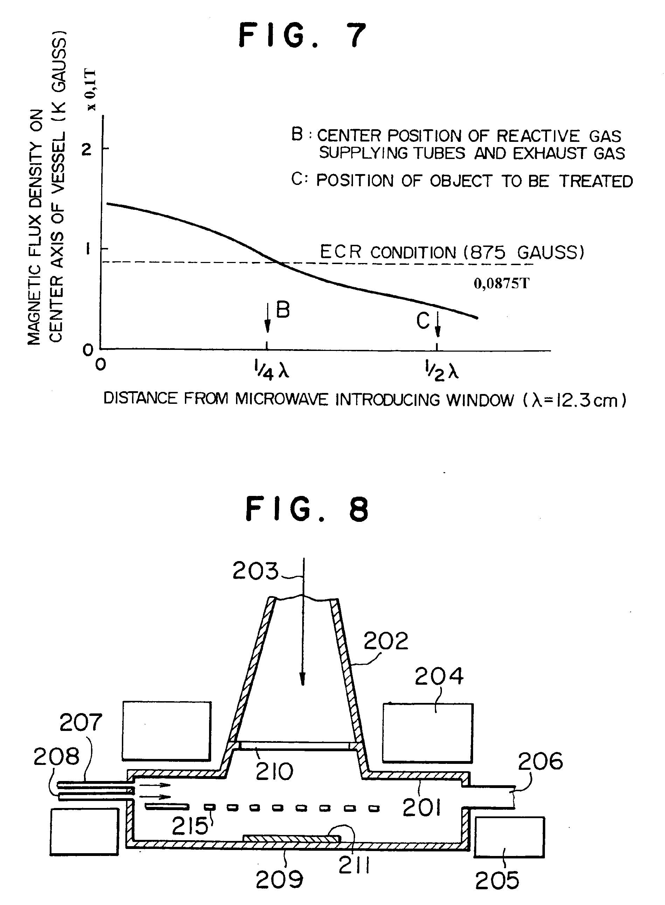

Fig. 6 shows a plasma treatment apparatus according to another embodiment of the present invention.

Referring to Fig. 6, a vacuum vessel 201 has an axial length thereof which is smaller than the diameter thereof. A microwave guide tube 202 is provided so as to introduce a microwave 203 in the axial direction of the vacuum vessel 201 from a microwave introducing window 210 provided at an upper end of the vacuum vessel 201. Reactive gas supplying tubes 207 and 208 and an exhaust port 206 are formed at a side face of the vacuum vessel 201, and an object 211 to be treated is disposed on a substrate supporting base 209 provided on the bottom of the vacuum vessel 201. The vacuum vessel 201 thus constructed has a diameter of 350 mm and an axial length of 62 mm. The microwave 203 supplied from the microwave guide tube 202 has a power of 300 W, a frequency of 2.45 GHz and a wavelength of 123 mm.

A relation between the center positions of the reactive gas supplying tubes 207, 208 and exhaust port, the position of the microwave guide tube 210 and the position of the object 211 to be treated is illustrated in Fig. 7. Fig. 7 shows the distribution of magnetic flux densities along the center axis of the vacuum vessel 201. Broken line in Fig. 7 shows the value of a magnetic flux density which satisfies a condition of ECR 0,0875T (875 Gauss) for the microwave 203 of 2.45 GHz. As is apparent, the ECR condition is satisfied at a position of 31 mm distanced from the microwave introducing window 210 by one-fourth of the wavelength $\lambda$ of the microwave, and this position corresponds to positions at which the reactive gases from the reactive gas supplying tubes 207 and 208 are introduced. The object 211 to be treated is at a position distanced from the microwave introducing window 210 by $(1/2)\lambda$. In Fig. 7, the point "0" represents the position of the microwave introducing window 210. The above-mentioned magnetic flux density distribution is obtained by controlling currents to magnetic field generation coils 204 and 205 provided at the other periphery of the vacuum vessel 201 as shown in Fig. 6. These magnetic field generation coils 204 and 205 are arranged in a manner distributed on both the sides of the reactive gas supplying tubes 207 and 208 in the axial direction of the vacuum vessel 201.

Next, explanation will be made of the case where a silicon wafer having a diameter of 100 mm is used as the object 211 to be treated, a surface of the object to be treated is placed in the face of the direction of propagation of the microwave 203 and a film of silicon dioxide ($SiO_2$) is to be formed.

In that case, the microwave 203 has a power of 300 W, a frequency of 2.45 GHz and a wavelength of 123 mm. Monosilane ($SiH_4$) and oxygen ($O_2$) are introduced at 20 ml/min and 80 ml/min from the reactive gas supplying tubes 207 and 208, respectively. The vacuum vessel 201 is evacuated so as to provide a pressure of 0,13 Pa (1 x $10^{-3}$ Torr) at which the reaction is made. The magnetic field generation coils 204 and 205 are controlled so as to satisfy the condition shown in Fig. 7.

At this time, a reflected version of the microwave 203 had a power of 20 W, the average rate of formation of a film was 60 nm/min, the index of refraction of the film deposited was 1.46, the rate of etching by buffer fluoric acid solution (HF : $NH_4F$ = 1 : 6) was 280 nm/min, and the ratio of Si to 0 in the film was 1.0 : 2.0.

For the purpose of comparison with effects obtained by the present embodiment, an exhaust port 206' was formed at a position shown by dotted line in Fig. 6 to lower the gas concentration in the ECR plane and a film was formed with such a construction. In this case, a reflected version of the microwave having an input power of 300 W had a power 250 W which is remarkably large as compared with that in the present embodiment, the rate of deposition of the film was one-tenth of that in the present embodiment, and the etching rate of the film deposited was 300 times as high as that in the present embodiment. Thus, the film formation characteristics were remarkably deteriorated.

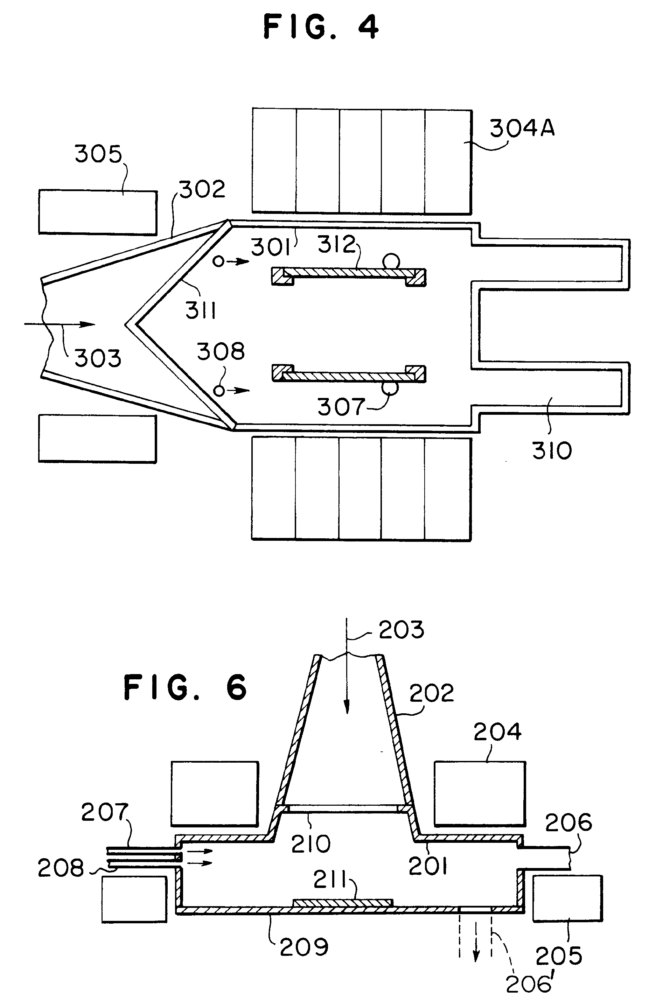

Fig. 3 shows the distribution of magnetic flux densities on the center axis of the vacuum vessel of the conventional plasma treatment apparatus of Fig. 2 based on the results of analysis thereof from the point of view as in the present embodiment. From Fig. 3, it is seen that the condition of Fig. 7 is not satisfied. Therefore, the results of formation of an $SiO_2$ film by use of the plasma treatment apparatus like the present embodiment were that though a reflected version of the microwave 203 having an input power of 300 W has a power of 10 W, the rate of formation of the film is 50 nm/min, the index of refraction of the film formed is 1.45, the etching rate of the formed film is 600 nm/min, and the ratio of Si to O in the film is 1.9 : 2.0. As is apparent from the comparison of these film formation characteristics and the above-described film formation characteristics in the present embodiment, the formation of a high absorption band of the microwave 203 by enhancing the concentration of reactive gas in the ECR plane as in the present embodiment makes it possible to shorten the axial length of the vacuum vessel 201 in the direction of propagation of the microwave without substantially changing the practical efficiency of the microwave and while improving the plasma treatment characteristics.

Fig. 8 shows a plasma treatment apparatus according to still another embodiment of the present invention. The apparatus of the present embodiment differs from the apparatus of the embodiment of Fig. 6 in that a porous dash board 215 is disposed on the side of the object 211 to be treated and parallel to the flow of the reactive gases from the reactive gas supplying tubes 207 and 208. The porous dash board 215 is made of quartz for the purpose of providing a conductance of the gases to suppress the diffusion of the reactive gases toward the object 211 to be treated.

The results of formation of an $SiO_2$ film by use of the plasma treatment apparatus of the present embodiment under a similar condition to that in the plasma treatment apparatus of the embodiment shown in Fig. 6, were that a reflected version of the microwave 203 having an input power of 300 W had a power of 1 W, the rate of formation of the film was 58 nm/min, the index of refraction of the film formed was 1.46, the etching rate of the film was 180 nm/min, and the ratio of Si to O in the film was 1.0 : 2.0. Accordingly, in the present embodiment, the film formation rate is somewhat decreased in comparison with the embodiment of Fig. 6 but the etching rate is reduced, thereby further improving the quality of the film.

Also in the present embodiment, since the reactive gas is let flow substantially parallel to the ECR plane to enhance the concentration of the reactive gas in the ECR plane, thereby forming a high absorption band of the microwave, the degree of transmission of the microwave 203 to the object 211 to be treated can be remarkably reduced and hence each of a distance between the microwave introducing window 210 and the object 211 and a distance between the object 211 and the ECR position can be shortened, thereby making the size of the vacuum vessel 201 in its axial direction or in the direction of propagation of the microwave small.

In the above-described embodiments of Figs. 6 and 8, the improvement of the practical efficiency of generation of a plasma and the reduction of the reflected microwave can be expected by establishing a relation between the position of the microwave introducing window 210, the ECR position and the position of the object 211 in such a manner that the microwave introducing window 210 is formed at a position where the strength of the alternate electric field of the microwave 203 introduced becomes substantially zero, the ECR position is located at a position distanced from the microwave introducing window 210 by $(1/4 + n)\lambda$ ($n = 0, 1, 2, ...$) and the object 211 is placed at a position distanced from the microwave introducing window 210 by $(1/2 + n)\lambda$. Also, if the magnetic fields generated by the magnetic field generating coils 204 and 205 has a distribution of magnetic flux densities which monotonically decrease in the direction of propagation of the microwave 203, a hindrance to introduction of the microwave 203 can be prevented. Further, the use of the vacuum vessel 201 having an axial length thereof in the direction of propagation of the microwave 203 smaller than a diameter thereof as shown in Figs. 6 and 8 is practically advantageous in obtaining the above-mentioned effects.

As has been explained above, in the embodiments shown in Figs. 6 and 8, since the reactive gas is introduced in the ECR plane formed substantially perpendicular to the direction of propagation of the microwave to produce a state in which the concentration of the reactive gas is high, it is possible to make small the size of the vacuum vessel, especially, in the direction of propagation of the microwave, without deteriorating the plasma treatment characteristics.

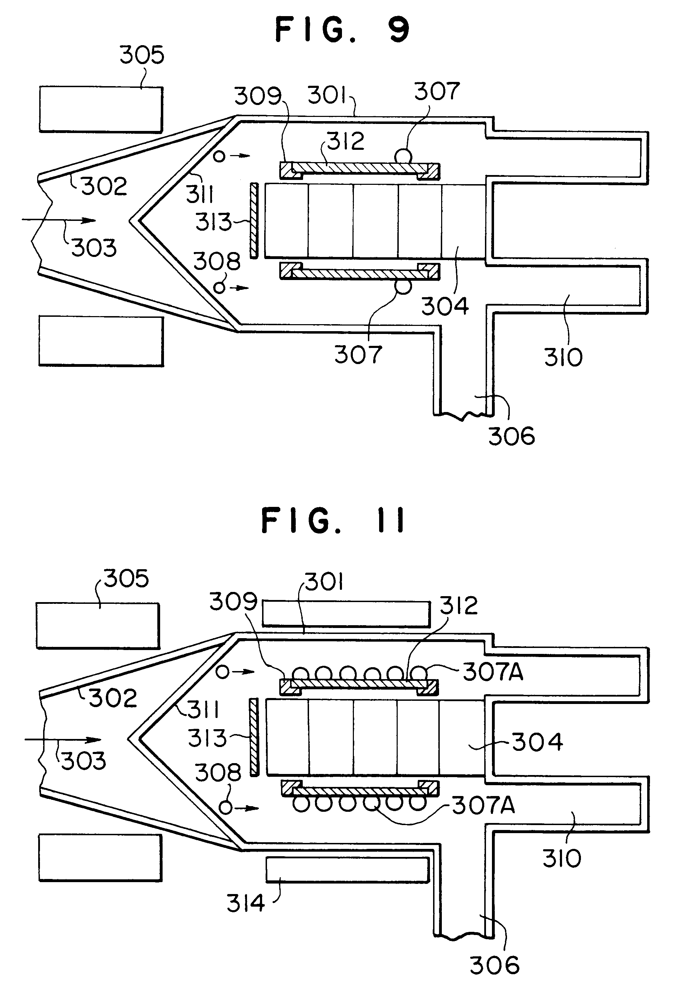

Fig. 9 shows schematically a main part of a plasma treatment apparatus according to a further embodiment of the present invention. The apparatus of the present embodiment comprises a vacuum vessel 301, a microwave guide tube 302 for guiding a microwave 303 from a microwave oscillator (not shown), a main magnetic field generation coil 304 (with iron core) for ECR generation, an auxiliary magnetic field generation coil 305, an exhaust port 306 (having an exhaust system not shown), a reactive gas supplying tube 307, a plasma gas supplying tube 308, a drum holder 309, a drum receiving chamber 310, and a magnetic shield plate 313.

The vacuum vessel 301 has a diameter of 450 mm⌀ and a length of 850 mm. One end of the vacuum vessel 301 is provided with a microwave introducing window 311 having a conic shape and made of quartz while the other end thereof is provided with the drum receiving chamber 310. The drum holder 309 is movable in the direction of the center axis of the vacuum vessel 301 and rotatable around the center axis of the vacuum vessel 301.

The auxiliary magnetic field generation coil 305 and the magnetic shield plate 313 are provided for reducing a magnetic field directed to the direction of propagation of the microwave to prevent any hindrance to propagation of the microwave.

Also, the reactive gas supplying tube 307 arranged along the surface of a drum 312 has 25 openings of 1 mm⌀ provided at equal intervals on the inner side of the tube or on the side of a surface to be treated with plasma.

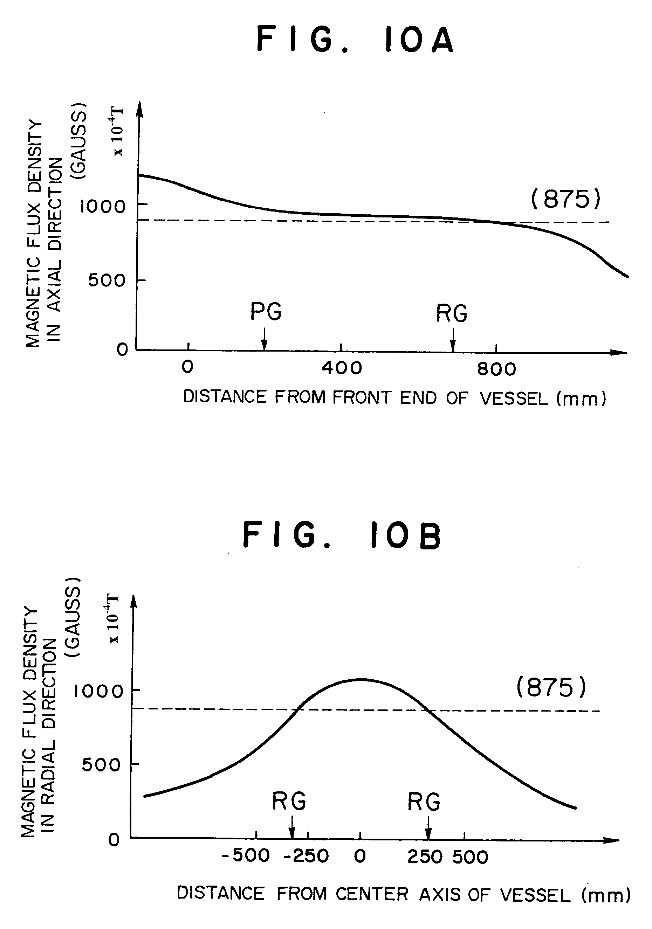

Figs. 10A and 10B show the distributions of magnetic flux densities obtained in the present embodiment as will be mentioned hereinbelow. Namely, Fig. 10A shows the magnetic flux density distribution along a direction of the drum 312 surface, and Fig. 10B shows the magnetic flux density distribution along a radial direction from the center axis of the vacuum vessel 301. In these figures, arrow PG on the abscissa represents the position of the plasma supplying tube 308 and arrow RG represents the position of the reactive gas supplying tube 307.

As seen from Fig. 10A, the magnetic field strength decreases gradually along the direction of progression of the microwave, and a magnetic field strength 0,0875T (875 Gauss) with which a condition of ECR is satisfied, is obtained in the vicinity of the position of the reactive gas supplying tube 307.

A control for realizing the magnetic flux density distributions shown in Figs. 10A and 10B was conducted by dividing the main magnetic field generation coil 304 into five coils as shown in Fig. 9 and adjusting the value of current supplied to each coil while adjusting the value of current supplied to the auxiliary coil 305.

For a comparison with Fig. 9, Fig. 4 shows the plasma treatment apparatus in which the same magnetic flux density distribution as that shown in Fig. 10A is formed by a main magnetic field generation coil 304A disposed outside of a vacuum vessel 301. In Fig. 4, the same or equivalent parts as or to those in Fig. 9 are designated with the same reference numerals as those in Fig. 9.

Referring to Fig. 4, the main magnetic field generation coil 304A is arranged outside of the vacuum vessel 301. It can readily be understood that in order to produce a magnetic field with a predetermined strength in the vicinity of a surface of an object to be treated, it is necessary to supply to the coil 304A a current having a magnitude which corresponds to a required supply current to the coil 304 of Fig. 9 multiplied by the ratio of the area of cross section of the coil 304A to that of the coil 304 or to select the number of windings of the coil 304A to a value which corresponds to the required number of windings of the coil 304 multiplied by the above-mentioned ratio.

From the comparison of Fig. 9 with Fig. 4, it is apparent that in the embodiment of Fig. 9, it is possible to make the size of the apparatus and the required current small by disposing the main magnetic field generation part inside of the object to be treated.

With the apparatus shown in Fig. 9, a cylindrical photoreceptor drum 312 (having a diameter of 262 mm$\varnothing$ and a length of 430 mm and made of Al) was used as the object to be treated, and a film of a-Si (amorphous silicon) was formed of a surface of the drum 312.

More especially in a first method, helium was introduced at 40 ml/min from the plasma gas supplying tube 308 while a monosilane ($SiH_4$) was blown at 40 ml/min from the reactive gas supplying tube 307 to the surface of the drum 312 in the vicinity of the tube 307. And, a magnetic field having a magnetic flux density of 0,0875T (875 Gauss) was generated between the center of the reactive gas supplying tube 307 and the surface of the photosensitive drum 312 by the magnetic field generation coils 304 and 305 so that a film of amorphous silicon (a-Si) is formed on the surface of the drum 312. During the film formation, the vacuum vessel 301 was evacuated such that a pressure in the vessel 312 is 0,01 Pa (1 x $10^{-4}$ Torr).

In this case, the distribution of film formation rates on the surface of the photoreceptor drum 312 facing the openings of the reactive gas supplying tube 307 was a Gaussian distribution which has the maximum rate of 2.5 μm/min and a Gaussian width of 1.3 cm. Therefore, the photoreceptor drum 312 was rotated at 60 r.p.m. by the drum holder 309 and was reciprocated 6 times per minute in the direction of the center axis of the vacuum vessel 301 so that an a-Si film having a thickness of 30 μm was formed on the entire surface of the drum 312.

The maximum error of film thickness was ±7% and a time required for forming the film was 120 minutes. The photoconductivity $\sigma_p$ of the film obtained was 3 x $10^{-6}$ S/cm and the dark conductivity $\sigma_d$ thereof was 2 x $10^{-13}$ S/cm. The maximum error of each conductivity was within ±3%.

Next or in a second method, a film of a-Si was formed in such a manner that monosilane is introduced from not the reactive gas supplying tube 307 but the plasma gas supplying tube 308 in a form mixed with helium. The film formation conditions including the gas flow amount were the same as those in the first method. As a result, 210 minutes was required for forming an a-Si film having a thickness of 30 μm. Though the degree of fluctuation of film thickness was the same as that in the first method, $\sigma_p$ was reduced to 2 x $10^{-8}$ S/cm and $\sigma_d$ was increased to 3 x $10^{-11}$ S/cm. Also, the maximum error of the photoconductivity $\sigma_p$ was ±9% and the maximum error of the dark conductivity $\sigma_d$ was ±11%. Namely, the degree of fluctuation of each conductivity was increased.

In forming the a-Si film in accordance with each of the first and second methods, an Si substrate was placed on the inner wall portion of the vacuum vessel 301 in the rear of the reactive gas supplying tube 307 in order to measure the weight of undesired substances or deposite which adhere to the Si substrate. The weight of undesired deposite in the case of the first method of reactive gas supply was about 100 times as large as that in the case of the second method of reactive gas supply.

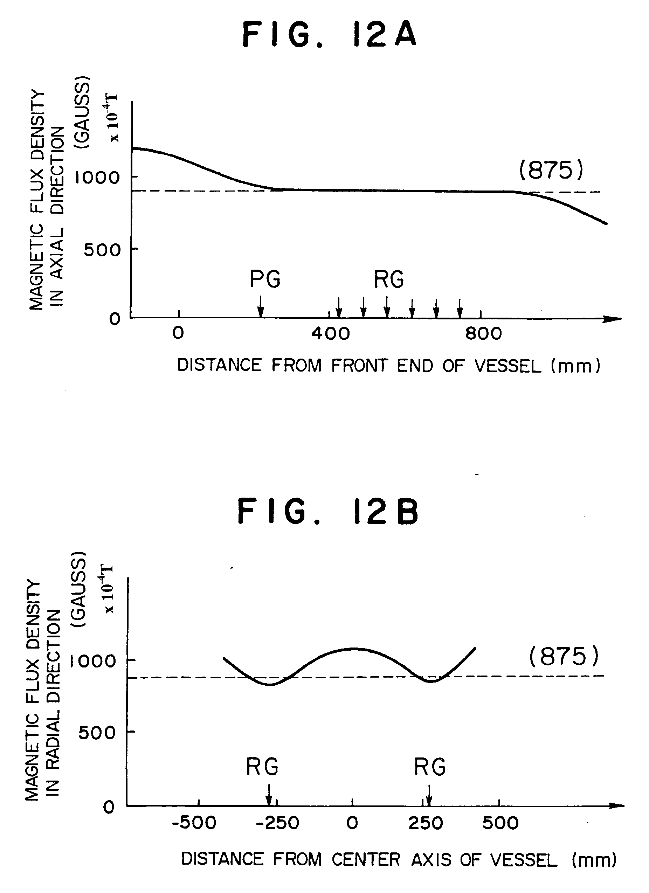

Fig. 11 shows in cross section a main part of a plasma treatment apparatus according to a still further embodiment of the present invention, and Figs. 12A and 12B show the distributions of magnetic flux densities in the apparatus of Fig. 11 similar to those shown in Figs. 10A and 10B. In Figs. 11 and 12, the same or equivalent parts as or to those in Figs. 9 and 10 are designated with the same reference numerals or symbols as those in Figs. 9 and 10.

The embodiment shown in Fig. 11 differs from the embodiment of Fig. 9 in that a reactive gas supplying tube is disposed in a multi-stage arrangement as indicated by reference numeral 307A in Fig. 11 (or a plurality of reactive gas supplying tubes 307 are provided) and that a coil 314 for generating a magnetic field for prevention of adhesion of undesired substances or deposite to the inner wall of the vacuum vessel 301 is disposed on the outer periphery of the vacuum vessel 301.

With the construction shown in Fig. 11, the magnetic flux density distribution in the axial direction of the vacuum vessel 301 as shown in Fig. 12A can be obtained or a condition of ECR can be satisfied in the most of a region over which the reactive gas supplying tube 307A is arranged. Further, a mirror magnetic field as shown in Fig. 12B can be formed in the radial (or radius) direction of the vacuum vessel 301.

A film of a-Si was formed on the surface of a photoreceptor drum 312 in such a manner that monosilane is supplied from the multi-stage reactive gas supplying tube 307A while the value of a current supplied to a main magnetic field generation coil 304 is adjusted so as to elongate the ECR region as shown in Fig. 12B.

The supply amount of monosilane was 40 ml/min and was equally distributed to six reactive gas supplying tubes 307A. The other conditions were the same as those in the embodiment of Fig. 9. As a result, the same or similar values as or to those in the embodiment of Fig. 9 were obtained for the quality of the film formed and a time required for forming the film could be reduced to 70 minutes.

Further, by additionally providing outside of the vacuum vessel 301 the magnetic field generation coil 314 for prevention of adhesion of undesired deposite and shaping the magnetic flux density distribution in the radial direction of the vacuum vessel 301 to form the mirror magnetic field as shown in Fig. 12A, the travel of ion seeds to the inner wall of the vacuum vessel could be suppressed so that the amount of undesired deposite adhered to the inner wall of the vessel is reduced to about one half of that in the embodiment of Fig. 9.

As has been mentioned above, according to the embodiments shown in Figs. 9 and 11, since the main magnetic field generation section is disposed inside of the object to be treated, there is an effect that the size of the apparatus can be made small.

Also, since the reactive gas is blown to the surface to be treated from a near distance so that a region having a high reactive gas concentration is formed in the vicinity of the surface to be treated and an ECR is caused in this region, the improvement of efficiency of treatment for film formation and the improvement and uniformalization of film quality can be made. Especially, in the case where an a-Si film is formed, the increase in photoconductivity and the reduction in dark current can be realized. In addition, the embodiments of Figs. 9 and 11 have an effect that the amount of undesired deposite adhered to a portion other than the desired surface to be treated, for example, to the inner walll of the vacuum vessel can be reduced.

Further, in the embodiment shown in Fig. 11, since a reactive gas supplying system is provided with a multi-stage or multi-tube construction and a condition of ECR is satisfied equally in the vicinity of the multi-stage reactive gas supplying system, there is an effect that the efficiency of treatment for film formation can be improved. Also, since a magnetic field generation coil is additionally disposed outside of the vacuum vessel so that a mirror magnetic field is generated in the radial direction of the vacuum vessel, there is an effect that the amount of undesired deposite adhered to the inner wall of the vacuum vessel can be further reduced.

In the embodiments shown in Figs. 9 and 11, the coil has been used for generating a magnetic field. However, it is of course that a permanent magnet may be used. Also, though the object to be treated having a cylindrical shape has been exemplified, the object may has a planar structure.

The photoreceptor drum 312 shown in Figs. 9 and 11 may be used as a mere support for the object to be treated. In this case, a (Si) substrate to be treated is stuck on the outer peripheral surface of the drum so that a film is formed on the substrate.

The effects common to the embodiments shown in Figs. 9 and 11 can be summarized as follows.

Since a main magnetic field generation section is disposed inside of an object to be treated, the size of the apparatus can be made small. Since the magnetic field generation section is placed near a surface of the object to be treated with plasma, a coil current can be reduced or the size of a magnet can be made small.

Since a region having a high reactive gas concentration is formed in the vicinity of the surface to be treated and an ECR position is caused to exist in this region, not only the improvement of plasma treatment efficiency and the improvement and uniformalization of film quality can be expected but also the efficiency of utilization of reactive gas can be remarkably improved and further the amount of undesired deposits adhered to the inner wall of a vacuum vessel can be reduced. As a result, the maintenance of the apparatus can be simplified or facilitated. Also, since the amount of non-reacted gases to be exhausted becomes less, the size of an exhaust system can be made small.

## Claims

1. A microwave plasma treatment apparatus comprising
   a vacuum vessel (1, 201),
   a first gas introducing port (6, 207) for introducing a first gas into said vacuum vessel,
   a second gas introducing port (7, 208) for introducing a second gas into said vacuum vessel,
   a magnetic field generating means (8a, 8b, 204) for producing a magnetic field in said vacuum vessel,
   microwave introducing means (2, 202) for introducing microwave into said vacuum vessel in such a manner that an electron cyclotron resonance portion is produced in the vacuum vessel by interaction of the magnetic field and the microwaves, and

substrate holder means (4, 38, 209) for supporting a substrate (5, 211) in said vacuum vessel, in such a way that the substrate surface to be treated is substantially perpendicular to the direction of said magnetic field,

characterized in that

the electron cyclotron resonance portion is located between said microwave introducing port (2, 202) on the one side and said substrate holder on the other side, and

said first gas introducing port (6, 207) and said second gas introducing port (7, 208) are disposed between said microwave introducing means and said electron cyclotron resonance portion.

2. A microwave plasma treatment apparatus comprising

a vacuum vessel (301),

a first gas introducing port (307) for introducing a first gas into said vacuum vessel,

a second gas introducing port (308) for introducing a second gas into said vacuum vessel,

a magnetic field generating means (304) for producing a magnetic field in said vacuum vessel,

microwave introducing means (302) for introducing microwave into said vacuum vessel in such a manner that an electron cyclotron resonance portion is produced in the vacuum vessel by interaction of the magnetic field and the microwaves, and

substrate holder means (309) for supporting a substrate in said vacuum vessel, in such a way that the substrate surface to be treated is substantially parallel to the direction of said magnetic field,

said electron cyclotron resonance portion being located between said microwave introducing port (302) on the one side and said substrate holder (309) on the other side, and

said first gas introducing port (307) and said second gas introducing port (308) being disposed between said microwave introducing means and said electron cyclotron resonance portion.

3. A plasma treatment apparatus according to claim 1 or 2, characterized in that reactive gas supplying tube (207, 208) and exhaust port (206) are positioned to provide a flow of said reactive gas substantially conformable with and parallel to said electron cyclotron resonance plane.

4. A plasma treatment apparatus according to claim 1 or 2, characterized in that the magnetic field generating means (8a, 8b, 8c, 8d, 204, 205) produces a distribution of magnetic field strengths which monotonically decrease in the direction of propagation of said microwave (3, 203).

5. A plasma treatment apparatus according to claim 1, characterized in that a porous dash board (215) is provided between said reactive gas supplying tube (207, 208) and an object (211) to be treated and substantially parallel to a flow of said reactive gas for suppressing the diffusion of said reactive gas to said object.

6. A plasma treatment apparatus according to claim 1, charcterized in that the axial length of said vacuum vessel (201) in the direction of propagation of said microwave (203) is made smaller than the diameter of said vacuum vessel.

7. A microwave plasma treatment apparatus according to claim 1 or 3, characterized in that auxiliary magnetic field generating means (8c, 8d, 205) for producing auxiliary magnetic field are disposed near said substrate to be treated.

8. A plasma treatment apparatus according to claim 7, characterized in that said reactive gas supplying tube (207, 208) and said exhaust port (206) are arranged between said two magnetic field generation coils (204, 205).


**Patentansprüche**

1. Mikrowellenplasmabearbeitungsvorrichtung, die umfaßt:
   - eine Vakuumkammer (1, 201),
   - einen ersten Gaseinlaß (6, 207) für das Einlassen eines ersten Gases in die Vakuumkammer,
   - einen zweiten Gaseinlaß (7, 208) für den Einlaß eines zweiten Gases in die Vakuumkammer,
   - einen Magnetfeldgenerator (8a, 8b, 204) für die Erzeugung eines magnetischen Feldes in der Vakuumkammer,

- Mikrowelleneinstrahler (2, 202) für das Einstrahlen von Mikrowellen in die Vakuumkammer, so daß sich ein Elektron-Cyclotronresonanzabschnitt in der Vakuumkammer durch die Wechselwirkung des magnetischen Feldes und der Mikrowellen bildet, und
- Substrathalter (4, 38, 209) als Halterung für ein Substrat (5, 211) in der Vakuumkammer, so daß die zu behandelnde Substratoberfläche im wesentlichen senkrecht auf der Richtung des magnetischen Feldes steht,

dadurch gekennzeichnet, daß

der Elektron-Cyclotronresonanzabschnitt sich zwischen dem Mikrowelleneinstrahler (2, 202) auf der einen Seite und dem Substrathalter auf der anderen Seite befindet, und

der erste Gaseinlaß (6, 207) und der zweite Gaseinlaß (7, 208) sich zwischen Mikrowelleneinstrahler und Elektron-Cyclotronresonanzabschnitt befinden.

2. Mikrowellenplasmabearbeitungsvorrichtung, die umfaßt:
- eine Vakuumkammer (301),
- einen ersten Gaseinlaß (307) für das Einlassen eines ersten Gases in die Vakuumkammer,
- einen zweiten Gaseinlaß (308) für den Einlaß eines zweiten Gases in die Vakuumkammer,
- einen Magnetfeldgenerator (304) für die Erzeugung eines magnetischen Feldes in der Vakuumkammer,
- Mikrowelleneinstrahler (302) für das Einstrahlen von Mikrowellen in die Vakuumkammer, so daß sich ein Elektron-Cyclotronresonanzabschnitt in der Vakuumkammer durch die Wechselwirkung des magnetischen Feldes und der Mikrowellen bildet, und
- Substrathalter (309) als Halterung für ein Substrat in der Vakuumkammer, so daß die zu behandelnde Substratoberfläche im wesentlichen senkrecht auf der Richtung des magnetischen Feldes steht,

wobei

der Elektron-Cyclotronresonanzabschnitt sich zwischen dem Mikrowelleneinstrahler (302) auf der einen Seite und dem Substrathalter (309) auf der anderen Seite befindet, und

der erste Gaseinlaß (307) und der zweite Gaseinlaß (308) sich zwischen Mikrowelleneinstrahler und Elektron-Cyclotronresonanzabschnitt befinden.

3. Plasmabearbeitungsvorrichtung nach Anspruch 1 oder 2, dadurch gekennzeichnet, daß das Zufuhrrohr für das reaktive Gas (207, 208) und der Auslaß (206) so angeordnet sind, daß das reaktive Gas im wesentlichen konform mit und parallel zur Elektron-Cyclotronresonanzebene strömt.

4. Plasmabearbeitungsvorrichtung nach Anspruch 1 oder 2, dadurch gekennzeichnet, daß der Magnetfeldgenerator (8a, 8b, 8c, 8d, 204, 205) für eine Verteilung des Magnetfeldes sorgt, in der es monoton in Ausbreitungsrichtung der Mikrowelle (3, 203) abnimmt.

5. Plasmabearbeitungsvorrichtung nach Anspruch 1, dadurch gekennzeichnet, daß sich eine poröse Aufprallplatte (215) zwischen dem Zufuhrrohr (207, 208) für das reaktive Gas und einem zu behandelnden Objekt (211) befindet und im wesentlichen parallel zum Fluß des reaktiven Gases steht, um die Diffusion des reaktiven Gases in das besagte Objekt zu verhindern.

6. Plasmabearbeitungsvorrichtung nach Anspruch 1, dadurch gekennzeichnet, daß die axiale Länge der Vakuumkammer (201) in Ausbreitungsrichtung der Mikrowellen (203) kleiner als der Durchmesser der Vakuumkammer ist.

7. Mikrowellenplasmabearbeitungsvorrichtung nach Anspruch 1 oder 3, dadurch gekennzeichnet, daß zusätzliche Magnetfeldgeneratoren (8c, 8d, 205) für die Erzeugung eines zusätzlichen Magnetfeldes in der Nähe des zu bearbeitenden Substrats angeordnet sind.

8. Plasmabearbeitungsvorrichtung nach Anspruch 7, dadurch gekennzeichnet, daß das Zufuhrrohr für reaktives Gas (207, 208) und der Auslaß (206) zwischen zwei Magnetfelderzeugungsspulen (204, 205) angeordnet sind.

## Revendications

1. Appareil de traitement par plasma en présence d'hyperfréquences, comprenant :
    un récipient sous vide (1, 201),

un premier accès d'introduction de gaz (6, 207) servant à introduire un premier gaz dans ledit récipient sous vide,

un deuxième accès d'introduction de gaz (7, 208) servant à introduire un deuxième gaz dans ledit récipient sous vide,

un moyen générateur de champ magnétique (8a, 8b, 204) servant à produire un champ magnétique dans ledit récipient sous vide,

un moyen (2, 202) d'introduction d'hyperfréquences servant à introduire des hyperfréquences dans ledit récipient sous vide de façon qu'une partie à résonance cyclotronique électronique soit produite dans le récipient sous vide par l'interaction du champ magnétique et des hyperfréquences, et

un moyen porte-substrat (4, 38, 209) destiné à porter un substrat (5, 211) dans ledit récipient sous vide, de façon que la surface du substrat à traiter soit sensiblement perpendiculaire à la direction dudit champ magnétique, caractérisé en ce que :

la partie à résonance cyclotronique électronique est placée entre ledit accès d'introduction d'hyperfréquences (2, 202) situé d'un premier côté et ledit porte-substrat situé de l'autre côté, et

ledit premier accès d'introduction de gaz (6, 207) et ledit deuxième accès d'introduction de gaz (7, 208) sont disposés entre ledit moyen d'introduction d'hyperfréquences et ladite partie à résonance cyclotronique électronique.

2. Appareil de traitement par plasma en présence d'hyperfréquences, comprenant :

un récipient sous vide (301),

un premier accès d'introduction de gaz (307) servant à introduire un premier gaz dans ledit récipient sous vide,

un deuxième accès d'introduction de gaz (308) servant à introduire un deuxième gaz dans ledit récipient sous vide,

un moyen générateur de champ magnétique (304) servant à produire un champ magnétique dans ledit récipient sous vide,

un moyen (302) d'introduction d'hyperfréquences servant à introduire des hyperfréquences dans ledit récipient sous vide de façon qu'une partie à résonance cyclotronique électronique soit produite dans le récipient sous vide par l'interaction du champ magnétique et des hyperfréquences, et

un moyen porte-substrat (309) servant à porter un substrat dans ledit récipient sous vide, de façon que la surface du substrat à traiter soit sensiblement parallèle à la direction dudit champ magnétique,

ladite partie à résonance cyclotronique électronique étant placée entre ledit accès d'introduction d'hyperfréquences (302) situé d'un premier côté et ledit porte-substrat (309) situé de l'autre côté, et

ledit premier accès d'introduction de gaz (307) et ledit deuxième accès d'introduction de gaz (308) étant disposés entre ledit moyen d'introduction d'hyperfréquences et ladite partie à résonance cyclotronique électronique.

3. Appareil de traitement par plasma selon la revendication 1 ou 2, caractérisé en ce qu'un tube (207, 208) d'alimentation en gaz réactif et un accès de décharge (206) sont placés de manière à produire une circulation dudit gaz réactif qui peut sensiblement s'adapter et est parallèle au plan de ladite résonance cyclotronique électronique.

4. Appareil de traitement par plasma selon la revendication 1 ou 2, caractérisé en ce que le moyen générateur de champ magnétique (8a, 8b, 8c, 8d, 204, 205) produit une répartition d'intensités de champ magnétique qui diminuent de façon monotone dans la direction de propagation des hyperfréquences (3, 203).

5. Appareil de traitement par plasma selon la revendication 1, caractérisé en ce qu'un panneau poreux (215) est prévu entre ledit tube d'alimentation en gaz réactif (207, 208) et un objet (211) à traiter et est sensiblement parallèle à la circulation dudit gaz réactif de façon à supprimer la diffusion dudit gaz réactif sur ledit objet.

6. Appareil de traitement par plasma selon la revendication 1, caractérisé en ce que la longueur axiale dudit récipient sous vide (201) suivant la direction de propagation desdites hyperfréquences (203) est rendue plus petite que le diamètre dudit récipient sous vide.

7. Appareil de traitement par plasma en présence d'hyperfréquences selon la revendication 1 ou 3, caractérisé en ce que des moyens générateurs de champ magnétique auxiliaire (8c, 8d, 205) servant à produire un champ magnétique auxiliaire sont disposés au voisinage dudit substrat à traiter.

8. Appareil de traitement par plasma selon la revendication 7, caractérisé en ce que ledit tube d'alimentation en gaz réactif (207, 208) et ledit accès de décharge (206) sont disposés entre lesdites deux bobines génératrices de champ magnétique (204, 205).

# FIG. 1A
# PRIOR ART

# FIG. 1B
# PRIOR ART

# FIG. 2
# PRIOR ART

# FIG. 3
# PRIOR ART

ECR CONDITION

DISTANCE FROM MICROWAVE
INTRODUCING WINDOW ($\lambda$=12.3 cm)

A — POSITION OF MICROWAVE
INTRODUCING WINDOW

B — POSITION OF PLASMA FLOW
OUTLET PORT

C — POSITION OF OBJECT TO BE
TREATED

MAGNETIC FLUX DENSITY ON CENTER
AXIS OF VESSEL (K GAUSS)

x 0,1T

18

# FIG. 4

305

302

304A

301 312

311

303

308

307

310

# FIG. 6

203

202

204

207

208

210

201

206

209

211

205

206'

# FIG. 5A

# FIG. 5B

FIRST PLASMA GENERATION REGION

SECOND PLASMA GENERATION REGION

PLASMA TRANSPORT REGION

ECR POINT

MAGNETIC FIELD STRENGTH

DISTANCE FROM MICROWAVE INTRODUCING WINDOW

# FIG. 7

MAGNETIC FLUX DENSITY ON CENTER AXIS OF VESSEL (K GAUSS)

x 0,1 T

B : CENTER POSITION OF REACTIVE GAS SUPPLYING TUBES AND EXHAUST GAS

C : POSITION OF OBJECT TO BE TREATED

ECR CONDITION (875 GAUSS)

0,0875T

DISTANCE FROM MICROWAVE INTRODUCING WINDOW ( $\lambda$ =12.3 cm)

# FIG. 8

# FIG. 9

# FIG. II

# FIG. IOA

MAGNETIC FLUX DENSITY IN AXIAL DIRECTION (GAUSS)

x 10⁻⁴T

(875)

1000

500

0

PG

RG

0    400    800

DISTANCE FROM FRONT END OF VESSEL (mm)

# FIG. IOB

MAGNETIC FLUX DENSITY IN RADIAL DIRECTION (GAUSS)

x 10⁻⁴T

(875)

1000

500

0

RG    RG

-500  -250    0    250  500

DISTANCE FROM CENTER AXIS OF VESSEL (mm)

EP 0 290 036 B1

# F I G. 12A

# F I G. 12B

24

# FIG. 13